# EUROPÄISCHE PATENTANMELDUNG

(11) **EP 1 343 000 A2**
(43) Veröffentlichungstag der Anmeldung: **10.09.2003**
(21) Anmeldenummer: 03004118.0
(22) Anmeldetag: 26.02.2003
(51) Int. Cl.: G01M 15/00, G01M 17/007

(54) **Diagnosesystem für ein Kraftfahrzeug**

(30) Priorität: 08.03.2002 DE 10210362
(71) Anmelder: ADAM OPEL AG, 65423 Rüsselsheim (DE)
(72) Erfinder: Cau, Fancesco, 65203 Wiesbaden (DE); Sattler-Schneider, Marcus, 55218 Ingelheim (DE)

(57) **Zusammenfassung**

Ein Diagnosesystem für ein Kraftfahrzeug ist mit mehreren Funktionssystemen des Kraftfahrzeuges zugeordneten, über ein Bus-System (2) miteinander gekoppelten Steuergeräten (1) ausgestattet, wobei das Bus-System (2) zur Einleitung der Diagnose über einen Diagnosestecker (5) mit einem Testgerät (6) in Verbindung steht. Dem Diagnosestecker (5) ist ein Funkmodul (4) zugeordnet, über das das Testgerät (6) mit dem Diagnosestecker (5) gekoppelt ist, wobei das Testgerät (6) zur Darstellung von Informationen mit einer in dem Kraftfahrzeug installierten Anzeigeeinrichtung (8) kommuniziert.

## Beschreibung

Die Erfindung bezieht sich auf ein Diagnosesystem für ein Kraftfahrzeug, das mit mehreren Funktionssystemen des Kraftfahrzeuges zugeordneten, über ein Bus-System miteinander gekoppelten Steuergeräten ausgestattet ist, wobei das Bus-System zur Einleitung der Diagnose über einen Diagnosestecker mit einem Testgerät in Verbindung steht.

Aus der DE 199 01 312 A1 ist eine Diagnose-Einrichtung für ein Kraftfahrzeug bekannt, die einen Mikroprozessor aufweist und zur Anzeige von im Kraftfahrzeug auftretenden Fehlern auf einem Display mit zu überwachenden Bauteilen in Verbindung steht. Der Mikroprozessor ist zum Auslesen von Fehlermeldungen in Fehlerspeichern elektronischer Steuerungen und Einrichtungen des Kraftfahrzeuges und zum Erzeugen einer Fehlerdiagnose auf dem Display ausgebildet.

Im Weiteren offenbart die DE 195 22 937 A1 ein Diagnosesystem mit einer Diagnoseeinrichtung zum Feststellen von Fehlern eines Kraftfahrzeuges, das eine elektronische Steuereinheit aufweist und mit einem Verbinder zur Kopplung der Diagnoseeinrichtung mit der elektronischen Steuereinheit versehen ist. Darüber hinaus ist ein externer Computer zur Verarbeitung von Daten, die von der Diagnoseeinrichtung übertragen werden, vorhanden. Eine in der Diagnoseeinrichtung installierte Datenleseeinrichtung liest über den Verbinder Daten aus der elektronischen Steuereinheit aus. Eine in der Diagnoseeinrichtung untergebrachte erste Datenanzeigeeinrichtung zeigt die Daten an. Eine in der Diagnoseeinrichtung vorgesehene Datensende-Funkeinrichtung dient zum Senden der Daten über Funk. Zum Empfang der Daten weist der externe Computer eine Datenempfangs-Funkeinrichtung auf. Um die Daten zu verarbeiten, weiterzugeben und anzuzeigen, ist der externe Computer mit Datenverarbeitungseinrichtungen und einer zweiten Datenanzeigeeinrichtung versehen.

Es ist Aufgabe der Erfindung, ein Diagnosesystem der eingangs genannten Art zu schaffen, das für einen Bediener während der Diagnose relativ einfach handhabbar ist.

Erfindungsgemäß wird die Aufgabe dadurch gelöst, dass dem Diagnosestecker ein Funkmodul zugeordnet ist, über das das Testgerät mit dem Diagnosestecker gekoppelt ist, wobei das Testgerät zur Darstellung von Informationen mit einer in dem Kraftfahrzeug installierten Anzeigeeinrichtung kommuniziert.

Dem Testgerät wird ein fester Standort außerhalb des Kraftfahrzeuges zugewiesen und der im Kraftfahrzeug befindliche Bediener liest die Fehlermeldungen auf der innerhalb des Kraftfahrzeuges angeordneten Anzeigeeinrichtung ab. Sonach ist es nicht erforderlich, dass der Bediener ein zusätzliches Display zur Anzeige der Fehlermeldungen mit sich führt, das ihn während seiner Tätigkeit, beispielsweise einer so genannten End-of-Line-Kontrolle bei der Herstellung des Kraftfahrzeuges, behindern würde. Ferner kann das Testgerät relativ kostengünstig ohne eigenes Display gestaltet sein. Dies führt wiederum zu einer Reduzierung des Wartungsaufwandes für das Testgerät. Im Übrigen erfolgt die Kommunikation zwischen dem Testgerät und den Steuergeräten über das mit dem Diagnosestecker gekoppelte Funkmodul, weshalb eine Verkabelung dieser Komponenten überflüssig ist. Nach der Kopplung des Funkmoduls mit dem Diagnosestecker ist im Kommunikationsbereich mit dem Testgerät die Diagnose eingeleitet, d.h. das Kraftfahrzeug befindet sich in einem Diagnosemodus und das Testgerät fragt die Fehlermeldungen der Steuergeräte ab oder nimmt eine Programmierung derselben vor. Die auf der Anzeigeeinrichtung dargestellten Informationen können sich sowohl auf Fehlermeldungen der Steuergeräte als auf Statusanzeigen des Testgerätes oder der Steuergeräte beziehen. Im Weiteren lassen sich Informationen darstellen, die Anweisungen für den Bediener enthalten. Bei dem Funkmodul kann es sich beispielsweise um ein so genanntes Bluetooth-Funkmodul oder um einen von dem so genannten Wireless LAN bekannten Baustein handeln.

Nach einer Ausgestaltung der Erfindung identifiziert das Funkmodul das Testgerät im Empfangsbereich selbsttätig. Damit einhergehend erfolgt die Adressierung des Testgerätes auf dem Bus-System ohne eine zusätzliche Programmierung.

Vorzugsweise sendet und empfängt das Funkmodul im Ultrahochfrequenzbereich. Das Funkmodul nutzt den Ultrahochfrequenzbereich beispielsweise bei ca. 2,4 Gigahertz und kommt mit einer relativ geringen Sendeleistung bei einer Kurzstreckenübertragung aus. Als Funkfrequenz kann insbesondere das globale Industrial-, Scientificund Medical-Band (ISM) verwendet werden.

Um Interferenzen zu vermeiden und die Verbindung zwischen den Steuergeräten bzw. dem Diagnosestecker und dem Testgerät stabil zu halten, wechselt vorteilhafterweise das Funkmodul nach dem Senden und/oder Empfangen eines Datenpaketes, das Fehlermeldungen der Steuergeräte und/oder Daten des Testgerätes umfasst, die Frequenz.

Nach einer vorteilhaften Ausgestaltung des Erfindungsgedanken ist das Funkmodul fest im Kraftfahrzeug installiert und dient zur bidirektionalen Datenfernübertragung von Geräten innerhalb des Kraftfahrzeuges zu Stationen außerhalb des Kraftfahrzeuges. Beispielsweise kann ein Rechner innerhalb des Kraftfahrzeuges mit einem Server außerhalb des Kraftfahrzeuges über das Funkmodul Verbindung aufnehmen, so dass eine Internetnutzung im Kraftfahrzeug gewährleistet ist.

Damit der Bediener des Testgerätes das Innere des Kraftfahrzeuges während der Diagnose nicht verlassen muss, erfolgt nach einer Weiterbildung der Erfindung eine Ansteuerung des Testgerätes mittels mindestens eines Betätigungselementes des Kraftfahrzeuges. Dem Betätigungselement werden nach der Einleitung der Diagnose rechnergesteuert entsprechende Funktionen zugewiesen.

Bevorzugt ist das Betätigungselement als Schalthebel eines Lenkstockschalters ausgebildet. Ein solcher Schalthebel ist zur Beaufschlagung zugeordneter Schaltkontakte in der Regel kreuzgelenkig gelagert, daher können ihm eine Vielzahl von Schaltfunktionen zugeordnet werden. Des Weiteren befindet sich dieser Schalthebel in einem für den Bediener gut erreichbaren Bereich innerhalb des Kraftfahrzeuges.

Vorteilhafterweise ist die Anzeigeeinrichtung in einem Armaturenbrett des Kraftfahrzeuges installiert. Diese Plazierung der Anzeigeeinrichtung hat den Vorteil einer verhältnismäßig guten Erkennbarkeit der auf der Anzeigeeinrichtung dargestellten Informationen für den Bediener.

Zur Einsparung einer zusätzlichen Anzeigeeinrichtung innerhalb des Kraftfahrzeuges ist zweckmäßigerweise die Anzeigeeinrichtung innerhalb eines Kombinationsinstrumentes oder einer Grafikanzeigeeinrichtung des Kraftfahrzeuges ausgebildet.

Bevorzugt weisen die Steuergeräte jeweils einen nicht flüchtigen Speicher für Fehlermeldungen auf. Um einen Abfragezyklus durch das Testgerät zu vermeiden, umfassen in Weiterbildung des Erfindungsgedankens die Steuergeräte eine Selbstüberwachungsfunktion und senden nach der Einleitung der Diagnose die Fehlermeldungen selbsttätig an das Testgerät.

Es versteht sich, dass die vorstehend genannten und nachstehend noch zu erläuternden Merkmale nicht nur in der jeweils angegebenen Kombination, sondern auch in anderen Kombinationen verwendbar sind, ohne den Rahmen der vorliegenden Erfindung zu verlassen.

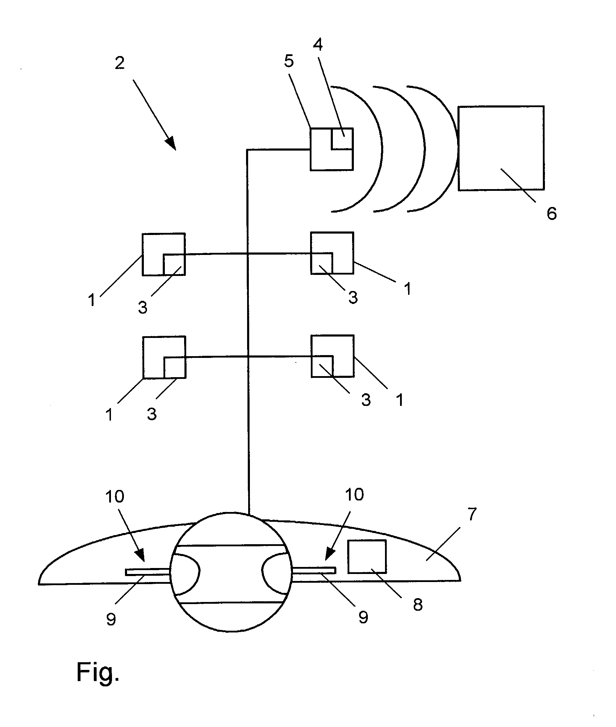

Die Erfindung wird im Folgenden anhand eines Ausführungsbeispieles unter Bezugnahme auf die zugehörige Zeichnung näher erläutert. Die einzige Fig. zeigt eine schematische Darstellung eines erfindungsgemäßen Diagnosesystems.

Das Diagnosesystem eines Kraftfahrzeuges umfasst mehrere Steuergeräte 1, die Funktionssystemen des Kraftfahrzeuges zugeordnet und über ein Bus-System 2 miteinander gekoppelt sind. Die Steuergeräte 1 sind mit einem nicht flüchtigen Speicher 3 für Fehlermeldungen ausgestattet. An das Bus-System 2 ist ein mit einem Funkmodul 4 gekoppelter Diagnosestecker 5 angebunden. Zur Fehlerdiagnose bzw. zum Empfang von Fehlermeldungen der Steuergeräte und zur Darstellung von Statusanzeugen sowie Informationen und Anweisungen für einen Bediener steht ein Testgerät 6 über das Funkmodul 4 mit dem Diagnosestecker 5 in Verbindung. Das Testgerät 6 bringt die Informationen, also die Fehlermeldungen der Steuergeräte 1 und weitere Informationen, auf einer in einem Armaturenbrett 7 des Kraftfahrzeuges installierten Anzeigeeinrichtung 8 zur Darstellung. Hierzu kommuniziert das Testgerät 6 über das Funkmodul 4 mit der an das Bus-System 2 angeschlossenen Anzeigeeinrichtung 8.

Bei einer Verbindung zwischen dem Funkmodul 4 und dem Testgerät 6 befindet sich das Kraftfahrzeug in einem Diagnosemodus und als Schalthebel 9 von Lenkstockschaltern ausgebildete Betätigungselemente 10 dienen zur Ansteuerung des Testgerätes 6, wobei die Ansteuerung ebenfalls über das Bus-System 2 sowie das Funkmodul 4 verwirklicht ist.

### Bezugszeichenliste

- 1.: Steuergerät
- 2.: Bus-System
- 3.: Speicher
- 4.: Funkmodul
- 5.: Diagnosestecker
- 6.: Testgerät
- 7.: Armaturenbrett
- 8.: Anzeigeeinrichtung
- 9.: Schalthebel
- 10.: Betätigungselement

## Patentansprüche

1. Diagnosesystem für ein Kraftfahrzeug, das mit mehreren Funktionssystemen des Kraftfahrzeuges zugeordneten, über ein Bus-System (2) miteinander gekoppelten Steuergeräten (1) ausgestattet ist, wobei das Bus-System (2) zur Einleitung der Diagnose über einen Diagnosestecker (5) mit einem Testgerät (6) in Verbindung steht, **dadurch gekennzeichnet, dass** dem Diagnosestecker (5) ein Funkmodul (4) zugeordnet ist, über das das Testgerät (6) mit dem Diagnosestecker (5) gekoppelt ist, wobei das Testgerät (6) zur Darstellung von Informationen mit einer in dem Kraftfahrzeug installierten Anzeigeeinrichtung (8) kommuniziert.

2. Diagnosesystem nach Anspruch 1, **dadurch gekennzeichnet, dass** das Funkmodul (4) das Testgerät (6) im Empfangsbereich selbsttätig identifiziert.

3. Diagnosesystem nach einem der Ansprüche 1 oder 2, **dadurch gekennzeichnet, dass** das Funkmodul (4) im Ultrahochfrequenzbereich sendet und empfängt.

4. Diagnosesystem nach einem der Ansprüche 1 bis 3, **dadurch gekennzeichnet, dass** das Funkmodul (4) nach dem Senden und/oder Empfangen eines Datenpaketes, das Fehlermeldungen der Steuergeräte (1) und/oder Daten des Testgerätes (6) umfasst, die Frequenz wechselt.

5. Diagnosesystem nach einem der Ansprüche 1 bis 3, **dadurch gekennzeichnet, dass** das Funkmodul (4) fest im Kraftfahrzeug installiert ist und zur bidirektionalen Datenfernübertragung von Geräten innerhalb des Kraftfahrzeuges zu Stationen außerhalb des Kraftfahrzeuges dient.

6. Diagnosesystem nach einem der Ansprüche 1 bis 4, **dadurch gekennzeichnet, dass** eine Ansteuerung des Testgerätes (6) mittels mindestens eines Betätigungselementes (10) des Kraftfahrzeuges erfolgt.

7. Diagnosesystem nach Anspruch 5, **dadurch gekennzeichnet, dass** das Betätigungselement (10) als Schalthebel (9) eines Lenkstockschalters ausgebildet ist.

8. Diagnosesystem nach Anspruch 1, **dadurch gekennzeichnet, dass** die Anzeigeeinrichtung (8) in einem Armaturenbrett (7) des Kraftfahrzeuges installiert ist.

9. Diagnosesystem nach Anspruch 1 oder 7, **dadurch gekennzeichnet, dass** die Anzeigeeinrichtung (8) innerhalb eines Kombinationsinstrumentes oder einer Grafikanzeigeeinrichtung des Kraftfahrzeuges ausgebildet ist.

10. Diagnosesystem nach Anspruch 1, **dadurch gekennzeichnet, dass** die Steuergeräte (1) jeweils einen nicht flüchtigen Speicher (3) für Fehlermeldungen aufweisen.

11. Diagnosesystem nach Anspruch 1 oder 8, **dadurch gekennzeichnet, dass** die Steuergeräte (1) eine Selbstüberwachungsfunktion umfassen und nach der Einleitung der Diagnose die Fehlermeldungen selbsttätig an das Testgerät (6) senden.
